# EUROPÄISCHE PATENTSCHRIFT

(11) **EP 2 943 826 B1**
(45) Veröffentlichungstag und Bekanntmachung des Hinweises auf die Patenterteilung: **02.08.2023**
(21) Anmeldenummer: 14700386.7
(22) Anmeldetag: 13.01.2014
(51) Int. Cl.: G02B 6/138, G02B 6/122, C08G 77/28, C08L 83/16, C09D 183/16, B29C 67/00

(54) **SCHICHTEN ODER DREIDIMENSIONALE FORMKÖRPER MIT ZWEI BEREICHEN UNTERSCHIEDLICHER PRIMÄR- UND/ODER SEKUNDÄRSTRUKTUR, VERFAHREN ZUR HERSTELLUNG DES FORMKÖRPERS UND MATERIALIEN ZUR DURCHFÜHRUNG DIESES VERFAHRENS**
LAYERS OR THREE-DIMENSIONAL SHAPED BODIES HAVING TWO REGIONS OF DIFFERENT PRIMARY AND/OR SECONDARY STRUCTURE, METHOD FOR PRODUCTION THEREOF AND MATERIALS FOR CONDUCTING THIS METHOD
COUCHES OU CORPS MOULÉS TRIDIMENSIONNELS COMPORTANT DEUX ZONES DE STRUCTURES PRIMAIRES ET/OU SECONDAIRES DIFFÉRENTES, PROCÉDÉ DE PRODUCTION DU CORPS MOULÉ ET MATÉRIAUX POUR LA MISE EN OEUVRE DE CE PROCÉDÉ

(30) Priorität: 11.01.2013 DE 102013100313; 06.05.2013 DE 102013104600
(43) Veröffentlichungstag der Anmeldung: 18.11.2015
(73) Patentinhaber: Fraunhofer-Gesellschaft zur Förderung der angewandten Forschung e.V., 80686 München (DE)
(72) Erfinder: WOLTER, Herbert, 97941 Tauberbischofsheim (DE); HOUBERTZ, Ruth, 97074 Würzburg (DE)
(74) Vertreter: Strehl Schübel-Hopf & Partner
(86) Internationale Anmeldenummer: PCT/EP2014/050514
(87) Internationale Veröffentlichungsnummer: WO 2014/108546

(56) Entgegenhaltungen:
- EP-A1- 2 357 186
- DE-A1- 10 152 878
- JOSEF KUMPFMUELLER ET AL: "Two-photon-induced Microfabrication of Flexible Optical Waveguides", JOURNAL OF LASER MICRO/NANOENGINEERING, Bd. 6, Nr. 3, 1. Dezember 2011 (2011-12-01), Seiten 195-198, XP055129252, DOI: 10.2961/jlmn.2011.03.0004

## Beschreibung

Die vorliegende Erfindung betrifft spezielle Schichten oder dreidimensionale Formkörper, die, hergestellt aus nur einem Material, Bereiche mit unterschiedlichen Primärstrukturen (d.h. chemischen Verknüpfungen, z.B. den Vernetzungsgrad beeinflussend oder aufgrund von erfolgten Umordnungen oder Umlagerungen) und/oder Sekundärstrukturen (hierunter soll vorliegend die Ordnung der Moleküle im Formkörperverbund verstanden werden, die z.B. durch Faltungen oder Verdichtungen beeinflusst wird) aufweisen. Die unterschiedliche Primär- und/oder Sekundärstruktur der unterschiedlichen Bereiche bewirkt, dass diese unterschiedliche physikalische oder mechanische Eigenschaften besitzen, zum Beispiel unterschiedliche Brechungsindizes oder einen unterschiedlichen Elastizitätsmodul. In einer spezifischen Ausführungsform ist ein erster Bereich mit vernetzten Strukturen vorhanden, während ein zweiter Bereich das Material in weiterhin (zumindest organisch) unvernetztem Zustand aufweist. Dieses kann anschließend ausgewaschen werden ("Entwicklung" der durch Vernetzung erzeugten Struktur), so dass eine zweidimensionale Schicht oder ein dreidimensionaler Formkörper mit nur einer Primär- bzw. Sekundärstruktur, aber spezifischen Formen, gebildet werden kann. Auf diese Weise können beispielsweise poröse Formkörper oder strukturierte Schichten erzeugt werden, ohne dass für letztere Maskenprozesse erforderlich sind. Die Erfindung betrifft weiterhin Verfahren zum Herstellen dieser Schichten oder Formkörper.

Die Herstellung dreidimensionaler Körper durch Bestrahlen vorbestimmter Volumenpixel (Voxel) in einem Badmaterial mit Hilfe von 2-Photonen-Polymerisation (2PP) ist seit geraumer Zeit bekannt. Erste Versuche gelangen mit rein organischen Materialien. WO 03/037606 A1 beschreibt die Herstellung dreidimensionaler Körper aus Polysiloxanen, die durch hydrolytische Kondensation von Silanen mit über Si-C-gebundenen organischen, durch Strahlung polymerisierbaren Gruppen hergestellt werden können. Grundlage des dort vorgestellten Polymerisationsprozesses ist die Zwei-Photonen-Polymerisation (auch als 2PP bezeichnet), induziert durch eine Zwei-Photonen-Absorption (auch als TPA bezeichnet), wobei festgestellt werden konnte, dass der Wechselwirkungsquerschnitt (die Wahrscheinlichkeit der 2P-Absorption) der eingesetzten Organopolysiloxane hinreichend groß war, um dieses Verfahren zur Erzeugung dreidimensionaler Strukturen, sei es in Form von (ggf. selbsttragenden) Körpern, sei es in Form von oberflächenstrukturierten oder sonstigen Schichten, die ggf. von einem Substrat gehalten werden, einzusetzen. In WO 03/037606 A1 wird eine lithographische Auflösung von ca. 100 nm mittels Femtosekundenlaser-Bestrahlung erwähnt, die jedoch noch nicht optimiert war.

Eine Vielzahl von Veröffentlichungen hat sich inzwischen dieser Thematik gewidmet; das Verfahren hat die früher übliche Stereolithographie durch seine hohe Auflösung, kleinste Strukturen im Bereich von 100 nm oder darunter und die dabei erreichbare sehr gute Oberflächengüte weitgehend abgelöst und verfeinert. Mit 2-Photonen-Polymerisation lassen sich beispielsweise biokompatible, bioresorbierbare oder biodegradierbare Strukturen erzeugen, die als Scaffolds zur Anbindung lebender Zellen oder für Implantate genutzt werden können. Auch diese Materialien können auf entsprechend modifizierten Polysiloxanen basieren, siehe WO 2011/98460 A1. Weitere Vorschläge betreffen die selektive Belichtung von Hydrogelen aus methacrylierten Poly(ε-caprolacton)basierten Oligomeren oder Poly(ethylenglycol)diacrylat mittels 2-PP-Polymerisation, siehe Jenni E. Koskela et al. in Polym. Adv. Technol. 23, 992-1001 (2012). Ein anderer Ansatz ist in WO 2011/147854 A1 offenbart. Diese Druckschrift beschäftigt sich mit der Herstellung strukturierter Formkörper sowie dünner oder auch dickerer Schichten aus auf photochemischem Wege organisch vernetzbaren metallorganischen Verbindungen, aus denen sich durch Sinterung und ggf. nachfolgende physikalische Aktivierung, beispielsweise Polarisation mit Hilfe eines elektrischen Feldes oder, falls magnetische Materialien darin enthalten sind, Aktivierung durch ein Magnetfeld, technisch relevante oxidische Funktionskörper oder-schichten herstellen lassen, z.B. in Form von magnetisch oder piezoelektrisch aktiven Sensoren oder Aktoren oder (Energie-)Wandlern wie Ultraschallwandlern aus PZT (Blei-Zirkonat-Titanat) oder BTO (Bariumtitanat).

In allen genannten Fällen wird der dreidimensionale Körper oder die strukturierte Oberfläche dadurch entwickelt, dass das nicht-belichtete Badmaterial ausgewaschen wird.

Es gibt Fälle, in denen der so hergestellte Körper anschließend in ein anderes Material eingebettet werden soll, das andere physikalische Eigenschaften besitzt. Ein prominentes Beispiel hierfür ist die Herstellung von Wellenleitern, die als "Core" in ein Cladding eingebettet werden müssen, um die gewünschte Brechzahldifferenz zwischen dem Medium des Wellenleiters selbst und dem angrenzenden Medium zu bewirken. Da polymerisierte Polysiloxane in aller Regel eine hohe Transmission für sichtbares Licht und auch angrenzende Bereiche aufweisen, sind sie potentielle Kandidaten für solche Wellenleiter. Dabei ist anzumerken, dass der gesamte Bereich von UV bis IR von Interesse ist: Materialien mit Transmission im sichtbaren oder sehr nahen Infrarot-Bereich sind z.B. für Multimode-Wellenleiter (genutzt wird z.B. eine Wellenlänge von 850 nm) sowie Gebrauchsgegenstände geeignet; Singlemode-Wellenleiter, die im Bereich der Datenübertragung eingesetzt werden, nutzen häufig die Wellenlängen 1310 und 1550 nm. UV-Licht wird im Bereich der Blu-ray(-DVD) Player eingesetzt. Je kleiner die genutzte Wellenlänge ist, desto engere, feinere Strukturen lassen sich erzeugen, was im Bereich der Datenträger bedeutet, dass sie auf derselben Fläche mehr Daten aufnehmen können als mit größeren Wellenlängen geschriebene.

Wellenleiter werden auch heute noch teilweise durch "klassisches" Belichten erzeugt. So schlagen z.B. Chunfang Ye et al. in Optics Express 20 (6), 6575-6583 (2012) vor, Wellenleiter durch direkt eingeschriebene Lithographie zu erzeugen. Als Basis dienen ihnen Photopolymere, die ursprünglich für die holographische Datenspeicherung entwickelt wurden. Diese Photopolymere umfassen eine feste, aber flexible Matrix sowie die photoaktiven Komponenten, nämlich einen geeigneten Photoinitiator sowie ein Monomer, das durch Reaktion mit dem angeregten Initiator polymerisiert. Die lokale Belichtung des Materials bewirkt, dass sich in den belichteten Bereichen das entstehende Polymer anreichert, während seine Konzentration aufgrund von Diffusionsprozessen in den nicht-belichteten Bereichen abnimmt. Die Autoren sehen hierin die Ursache für einen lokalen Anstieg des Brechungsindex'. Nach Abschluss der selektiven Belichtung wird das gesamte Material belichtet, um verbliebenen Initiator und verbliebenes Monomer "aufzubrauchen", und es entsteht ein chemisch und optisch nicht mehr reaktives Material, dessen optische Eigenschaften sich in den selektiv belichteten Bereichen von den nicht-selektiv belichteten Bereichen unterscheidet. Die beiden Bereiche könnten als "Core" und "Cladding" eines Wellenleiters genutzt werden.

Es hat auch bereits Versuche gegeben, 2PP-Polymerisation für ähnliche Verfahren zu nutzen. J. Kumpfmüller et al. schlagen in Journal of Laser Micro-Nanoengineering 6 (3), 195-198 (2011) vor, ein Siliconpolyetheracrylatharz als Basis zu verwenden, das mit Hilfe eines Rheologie-Additivs thixotrop gemacht wurde. Dieser Mischung wurden Trimethylolpropantriacrylat und ein Photoinitiator zugesetzt. Die Autoren konnten anhand von Phasenkontrasten die Erzeugung von Strukturen zeigen, die sich als Wellenleiter eignen könnten. Auch diese Gruppe geht davon aus, dass die unterschiedlichen Eigenschaften der unterschiedlich belichteten Materialien auf der Diffusion des Monomeren beruhen. Allerdings ist ein thixotropes Material als "Cladding" eines Wellenleiters nicht geeignet, da es mechanisch nicht stabil ist und die optische Qualität häufig zu gering ist.

S. Bichler, S. Feldbacher, R. Woods, V. Satzinger, V. Schmidt, G. Jakopic, G. Langer, W. Kern in Optical Materials 34 (2012) 772-780 stellten ein Material her, dessen Matrix durch Umsetzung eines Hydridosilans mit einem Vinylsilan durch klassische Hydrosilylierung (in Gegenwart eines Platin-Katalysators) erzeugt wurde. Als Monomere dienten Benzylmethacrylat oder Phenylmethacrylat, die aufgrund ihres hohen Brechungsindex' ausgewählt wurden. Ethylenglycol-dimethacrylat diente als Vernetzer für die photoinduzierte Polymerisation. Als Photostarter wurde Irgacure^{®} 379 verwendet. In einem ersten Schritt wurde das Material aufgeheizt, wobei sich die Siloxan-Matrix bildete, in der das monomere Material gelöst vorlag. Es folgte eine selektive 2PP-Belichtung zur Erzeugung von optischen Wellenleitern, und schließlich wurde das nicht umgesetzte Monomer durch Vakuumextraktion aus dem Bereich der nicht belichteten Matrix extrahiert, um diese zu stabilisieren. Die photoinduzierte Polymerisationsreaktion der Methacrylat-Monomeren wurde mit Hilfe von FTIR-Spektroskopie und Phasenkontrastmikroskopie beobachtet. Die für die Herstellung der Matrix verwendete Hydrosilylierung führt zu Silicongummi, so dass die erzeugten Wellenleiter-Strukturen wie auch die umgebende Matrix flexibel waren.

Es besteht weiterhin ein Bedarf an Materialien zur Herstellung struktureller Netzwerke, die beliebige Formen besitzen können, beispielsweise nano- oder mikrostrukturiert sind, die z.B. im Bereich der 3D optischen Interconnects oder aufgrund von Bereichen mit unterschiedlichem E-Modul nutzbar sind, und die innerhalb eines aus einem einzigen Material hergestellten Festkörpers Bereiche mit unterschiedlichen Primär- und/oder Sekundärstrukturen, wie einleitend definiert, besitzen. Insbesondere besteht ein Bedarf an Materialien, mit denen sich auf sehr einfache Weise feste, stabile Strukturen herstellen lassen, die innerhalb ihrer Struktur (d.h. innerhalb des Festkörpers, aus dem die Struktur besteht) unterschiedliche physikalische, beispielsweise unterschiedliche optische oder mechanische Eigenschaften besitzen.

Die Erfinder der vorliegenden Erfindung konnten überraschenderweise feststellen, dass hier Abhilfe geschaffen werden kann, und zwar durch den Vorschlag, ein mit einem über eine Zwei- oder Mehrphotonenpolymerisation polymerisierbaren organischen Rest modifiziertes polysiloxanhaltiges Material bereitzustellen, das in allen Fällen ein organisches Monomer enthält, welches Gruppen aufweist, die sich bei der Zwei- oder Mehrphotonenpolymerisation in das hierbei entstehende Polymer einpolymerisieren lässt, und dieses Material einer (örtlich) selektiven 2-Photonen-Polymerisation und außerdem im Gesamten einem thermischen und/oder photochemischen Bearbeitungsschritt zu unterwerfen, wobei der erstere der genannten Schritte vor oder nach der 2- oder Mehr-Photonen-Polymerisation durchgeführt wird.

Überraschenderweise konnten die Erfinder nämlich feststellen, dass bei Einsatz dieses Materials und diesem Verfahrensablauf eine selektiv belichtete Struktur eingebettet in ein vollständig verfestigtes Material oder in direkter Nachbarschaft zu diesem entsteht, wobei der selektiv belichtete Bereich im Vergleich zum nicht-selektiv belichteten Bereich strukturelle Änderungen, wie eine unterschiedliche Primär- und/oder Sekundärstruktur, wie oben definiert aufweist, darunter möglicherweise bzw. in manchen Fällen eine höhere Vernetzung der organischen Komponenten im selektiv belichteten Bereich. Die Tatsache, dass der photochemische Bearbeitungsschritt eine Belichtung bis über die Sättigungsgrenze des 2- oder Mehr-Photonen-Polymerisationsprozesses hinaus umfassen kann und dass stattdessen oder zusätzlich eine Belichtung des gesamten Materials vor dem selektiven Belichten erfolgen kann, legt jedoch nahe, dass es sich bei den Unterschieden nicht notwendigerweise um Unterschiede im Grad der Vernetzung des organischen Netzwerks handeln muss, sondern dass andere Effekte, wie Umordnungsprozesse, Umlagerungen oder Verdichtungen (z.B. unter Spannungsabbau) eine Rolle spielen, die möglicherweise auch eine anorganische Nachvernetzung (d.h. die Ausbildung höher molekularer Einheiten) zur Folge haben, obwohl das Material, sofern es nach dem Sol-Gel-Prozess hergestellt ist, bereits zuvor den unter den gewählten Bedingungen möglichen maximalen Kondensationsgrad erreicht hatte. Diese strukturellen Unterschiede haben unterschiedliche physikalische Eigenschaften zur Folge. So kann die selektiv belichtete Struktur einen Brechungsindex aufweisen, der sich von dem des umgebenden bzw. benachbarten, vollständig verfestigten Materials in geeigneter Weise unterscheidet und insbesondere höher ist, so dass die gebildete Struktur z.B. als "Core" und "Cladding" aufweisender Wellenleiter genutzt werden kann, oder die beiden Bereiche können unterschiedliche mechanische Eigenschaften, wie unterschiedliche Elastizitätsmoduli oder Festigkeiten, aufweisen.

Der Ausdruck "2-PP" soll nachstehend jeweils nicht nur die 2-Photonen-Polymerisation umfassen, sondern auch Polymerisationsreaktionen, die unter Absorption von mehr als 2 Photonen erfolgen, also sogenannte Mehr-Photonen-Polymerisationen (M-PP). Die 2- oder Mehr-Photonenpolymerisation wird ausgelöst durch die 2- oder Mehr-Photonen-Absorption, bezeichnet als TPA (2-Photonen-Absorption) bzw. MPA (Mehr-Photonen-Absorption). Nachstehend soll die Verwendung des Ausdrucks TPA jedoch immer bedeuten, dass auch die MPA umfasst ist.

Wird nachstehend der Ausdruck "(Meth)Acryl" verwendet, so ist darunter entweder die Methacrylgruppe und/oder die Acrylgruppe zu verstehen. Vergleichbares gilt für die Ausdrücke "(Meth)Acrylat", "(Meth)Acrylamid" und "(Meth)Acrylthioester".

Eine Vielzahl von teilweise bekannten Materialien kann als modifiziertes polysiloxanhaltiges Material dienen. Bedingung ist, dass das Material Gruppen aufweist, die über eine TPA bzw. MPA polymerisierbar sind, wobei sowohl die Bildung von Additionspolymeren aus C=C-doppelbindungshaltigen Strukturen allein als auch von Thiol-En-Additionsprodukten möglich ist. Wenn das Material nicht-aromatische C=C-Doppelbindungen aufweist, z.B. isolierte Doppelbindungen wie Vinylgruppen oder in Allyl- oder Styrylgruppen oder in α,β-ungesättigten Carbonylverbindungen, kann unter den Bedingungen der TPA eine Polymerisationsreaktion (engl.: "addition polymerization; chain growth polymerization) zwischen den C=C-Gruppen erfolgen. Außerdem können isolierte Doppelbindungen unter diesen Bedingungen durch Thiolgruppen angegriffen werden, und zwar auch solche, die aufgrund möglicher sterischer Hinderung oder aus anderen Gründen einer Polymerisation der C=C-Bindungen alleine nicht zugänglich sind, beispielsweise Norbornenylgruppen. Auch manche Ringsysteme, z.B. gespannte Ringe, können der TPA unterworfen werden, z.B. Epoxygruppen enthaltende Systeme, wobei diese kationisch polymerisiert werden, während die obigen C=C-Polymerisations- und Thiol-En-Additions-Reaktionen radikalisch verlaufen. Alle diese Gruppen sollen nachstehend unter den Begriff "organische, über Zwei- oder Mehrphotonenpolymerisation polymerisierbare Gruppe" fallen. In den Materialien, in denen die genannten Gruppen bereits der TPA unterworfen werden, werden diese Gruppen als "organische, über Zwei- oder Mehrphotonenpolymerisation polymerisierte Gruppen" bezeichnet.

Die Erfinder haben festgestellt, dass für die geeigneten Materialien zumindest ein Teil der Gruppen, die über eine TPA Polymere bilden können, an einem metall- oder halbmetallhaltigen Oligomeren oder Polymeren angebunden sein sollten, wobei die Anbindung der Reste, die die genannten Gruppen aufweisen, über ein Kohlenstoffatom an ein Siliciumatom und ggf. ein Metall im Verbund eines organisch modifizierten Polysiloxans oder Kieselsäure(hetero)polykondensats erfolgt. Möglicherweise beruhen die nun erstmals festgestellten Effekte auf der Tatsache, dass die organisch polymerisierbaren Komponenten im erfindungsgemäß einsetzbaren Material aufgrund der Anbindung an die jeweiligen Metalle/Halbmetalle in das anorganische Netzwerk integriert sind und deshalb kein vom anorganischen Netzwerk separates Netzwerk ausbilden können.

Erfindungsgemäß wird damit eine Schicht oder ein dreidimensionaler Formkörper gemäß Anspruch 1 bereitgestellt, wobei der Körper zwei Bereiche aufweist, die strukturell, d.h. bezüglich ihrer Primärstrukturen bzw. Sekundärstrukturen, wie oben definiert, unterschiedlich sind und dabei vorzugsweise unterschiedliche Vernetzungsgrade und/oder unterschiedliche Brechungsindizes und/oder E-Module aufweisen, erhältlich durch das folgende Verfahren:
a) Bereitstellen eines Substrats oder einer Form,
b) Bereitstellen eines Materials, ausgewählt unter organisch modifizierten, polysiloxanhaltigen Materialien, wobei das bereitgestellte Material die folgenden Komponenten aufweist:
   (i) mindestens ein organisch modifiziertes Polysiloxan mit Gruppen, die über eine 2- oder Mehrphotonenpolymerisationsreaktion polymerisierbar sind, bei welcher die Bildung entweder von C=C-Additionspolymeren und/oder von Thiol-En-Additionsprodukten möglich ist, wobei mindestens ein Teil dieser Gruppen über ein Kohlenstoffatom an das Polysiloxan angebunden vorliegt, und
   (ii) mindestens ein organisches Monomer, das mindestens einen Rest enthält, der sich mit Resten, die derselben 2- oder Mehrphotonenpolymerisation zugänglich sind wie die Gruppen des organisch modifizierten Polysiloxans gemäß (i), photochemisch copolymerisieren oder an diese addieren lässt,
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) thermisches oder photochemisches Behandeln des gesamten auf dem Substrat bzw. in der Form befindlichen Materials, um das gesamte auf dem Substrat oder in der Form befindliche Material zu verfestigen,
mit der Maßgabe, dass die Schritte d) und e) in beliebiger Abfolge durchgeführt werden können.

In einer Reihe von Ausführungsformen ist es dabei bevorzugt, das gesamte Material gemäß Schritt e) zu härten, nachdem die selektive Belichtung stattgefunden hat.

Die Erfindung betrifft auch das Verfahren zur Herstellung der Schicht oder des dreidimensionaler Formkörpers.

Bei dem Material gemäß (b) handelt es sich um ein Polysiloxan bzw. organisch modifiziertes Kieselsäure(hetero)polykondensat.

Beispiele solcher Polysiloxane bzw. Kieselsäure(hetero)polykondensate sind in WO 03/037606 A1 offenbart, d.h. Polysiloxane, die durch Hydrolyse und mindestens teilweise Kondensation eines Ausgangsmaterials erhältlich sind, das mindestens ein Silan der Formel (I)

R¹ₐR²_{b}SiX_{4-a-b} (I)

aufweist, worin R¹ gleich oder verschieden ist und einen organischen, über Zwei- oder Mehrphotonenpolymerisation polymerisierbaren Rest darstellt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind. Als Reste R¹ eignen sich vorwiegend, aber nicht ausschließlich C=C-Doppelbindungen enthaltende Reste, darunter neben Vinyl- oder Allylresten insbesondere Reste, die eine α,β-ungesättigte Carbonylverbindung aufweisen, sowie doppelbindungshaltige Ring- und insbesondere kondensierte Ringsysteme wie der Norbornenyl-Rest und Derivate davon, die beispielsweise eine der folgenden Strukturen aufweisen:

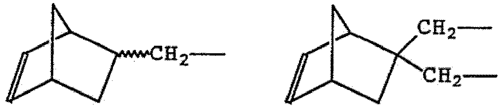

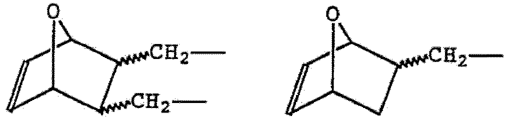

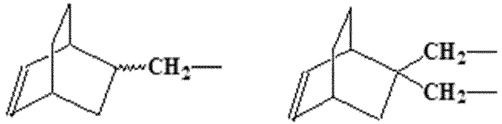

Die Herstellung von organisch modifizierten Polysiloxanen oder Kieselsäurekondensaten (häufig auch als "Silanharze" bezeichnet) und deren Eigenschaften ist in einer Fülle von Publikationen beschrieben worden. Stellvertretend sei hier z.B. auf Hybrid Organic-Inorganic Materials, MRS Bulletin 26(5), 364ff (2001) verwiesen. Ganz allgemein werden solche Substanzen in der Regel mit Hilfe des sogenannten Sol-Gel-Verfahrens hergestellt, indem hydrolyseempfindliche, monomere oder präkondensierte Silane, ggf. in Gegenwart weiterer cokondensierbarer Substanzen, wie Alkoxiden des Bor, Germanium oder Titan, sowie ggf. von zusätzlichen Verbindungen, die als Modifikatoren oder Netzwerkwandler dienen können, oder von sonstigen Additiven, wie Füllstoffen, einer Hydrolyse und Kondensation unterworfen werden. Materialien, die sich für die vorliegende Erfindung eignen, sind beispielsweise in DE 4011 044C2, DE 196 27 198, EP 450 624 B1, EP682 033 B1, EP 1 159 281 B1, EP 1 685 182 B1, EP 1 874 847 B1, EP 1 914 260 A1, WO 2003/037606 A1, WO 2011/098460 A1 und WO2011/141521 aufgelistet. Diese Materialien zeichnen sich dadurch aus, dass sie über Kohlenstoff an Silicium gebundene Reste besitzen, die eine oder mehrere organisch durch 2PP (TPA) polymerisierbare Gruppen R¹ aufweisen. In den meisten dieser Materialien sind bzw. können Acryl- und Methacrylgruppen vorhanden sein, die dem obigen Rest R¹ entsprechen; alternativ sind z.B. Norbornenyle sowie Homologe dazu oder andere kondensierte doppelbindungshaltige Systeme, wie Vinyl-, Allyl- oder Styrylgruppen, als Rest R¹ geeignet. Bezüglich einsetzbarer Norbornenylsilane und verwandter Verbindungen kann auch auf die bereits oben erwähnte DE 196 27 198 A1 verwiesen werden. So kann u.a. der Norbornenring selbstverständlich ggf. substituiert sein; auch kann anstelle des Norbornen-Restes (d.h. des Bicyclo[2.2.1]heptenrestes) ein Bicyclo[2.2.2]octen-Rest vorhanden sein. Weiterhin kann der doppelbindungshaltige Fünfring des kondensierten Systems ein Sauerstoffatom enthalten, wenn die (Meth)Acrylgruppe mit Furan anstelle von Cyclopentadien umgesetzt wird.

Die obige Liste ist jedoch nicht als abschließend zu verstehen, was sich auch den nachstehenden Erläuterungen entnehmen lässt.

Insbesondere lassen sich erfindungsgemäß auch siliciumbasierte Harze/Lacke einsetzen, wie sie in der WO 93/25604 oder der DE 199 32 629 A1 beschrieben sind. Darunter bevorzugt sind die modifizierten Kieselsäurepolykondensate der DE 199 32 629 A1, da diese unter Verwendung von Silandiolen sowie Alkoxysilanen hergestellt sind, weshalb die Kondensation der Silanverbindungen zur Bildung von ausschließlich Alkohol, nicht aber von Wasser erfolgt. Ganz besonders bevorzugt sind Co-Kondensationsprodukte der Verbindungen Ar₂Si(OH)₂ und R¹Si(OR')₃, worin Ar ein aromatischer Rest mit 6 bis 20 Kohlenstoffen, insbesondere ggf. substituiertes Aryl und ganz besonders bevorzugt ein direkt an das Silicium gebundener, unsubstituierter Phenylrest ist und R¹ die für Formel (I) angegebene Bedeutung besitzt und vorzugsweise mindestens eine Epoxygruppe oder eine C=C-Doppelbindung, insbesondere eine einer Michaeladdition zugängliche Doppelbindung, aufweist (z.B. eine (Meth-)Acrylatgruppe ist).

Ganz besonders bevorzugt ist R¹ in dieser Kombination eine Methacryloxyalkyl, z.B. eine Methacryloxypropylgruppe. Auch Co-Kondensationsprodukte, in denen Ar₂ und/oder R¹ Styrylgruppen darstellen, sind möglich. Die Herstellung eines Silankondensates aus einer Mischung von Diphenylsilandiol und 3-Methacryloxypropyltrimethoxysilan im Molverhältnis 1:1 ist in der genannten DE 199 32 629 A1 in Beispiel 1 beschrieben; das gewählte Verhältnis führt dazu, dass die Hydrolyse durch Einsatz ausschließlich katalytischer Mengen an Wasser erfolgt. So lassen sich Materialien herstellen, die aufgrund des Fehlens von Schwingungen der OH-Gruppe im Telekommunikationsbereich bei 1310 und 1550 nm eine niedrige Absorption aufweisen.

Es ist bevorzugt, dass die Zwei- oder Mehrphotonenpolymerisation über eine bzw. mehrere Gruppen erfolgt, die sich radikalisch polymerisieren lassen. Zwar sind auch solche Systeme erfindungsgemäß geeignet, die sich mit Hilfe eines kationischen UV-Starters polymerisieren lassen, beispielsweise ringöffnende Systeme wie Epoxysysteme (siehe z.B. C.G. Roffey, Photogeneration of Reactive Species for UV Curing, John Wiley & Sons Ltd, (1997)). Doch neigen diese Systeme zu parasitärer Polymerisation, d.h. es findet auch eine Polymerisation in die nicht belichteten Bereiche hinein statt, weswegen sie für Anwendungsbereiche mit extremen Anforderungen an die Feinheit und Glätte der Oberflächen, z.B. hochaufgelöste Lithographie, weniger gut geeignet sind.

Bevorzugt enthält der Rest R¹ in Formel (I) oben eine oder mehrere nichtaromatische C=C-Doppelbindungen, besonders bevorzugt einer Michael-Addition zugängliche Doppelbindungen, z.B. α,β-ungesättigte Carbonylverbindungen. Dies können Acryl- oder Methacrylgruppen sein, insbesondere in Form der (Meth)Acrylate, (Meth)Acrylamide und (Meth)Acrylthioester. R² kann eine ggf. substituierte Alkyl-, Aryl-, Alkylaryl- oder Arylalkylgruppe sein, wobei die Kohlenstoffkette dieser Reste ggf. durch O, S, NH, CONH, COO, NHCOO oder dgl. unterbrochen sein kann. R² kann dabei auch Gruppen enthalten, die mit C=C-Doppelbindungen eine Additionsreaktion eingehen können, oder eine für biologische Zwecke relevante Gruppe enthalten, wie aus WO 2011/98460 A1 bekannt. Die Gruppe X ist in der Regel Wasserstoff, Halogen, Alkoxy, Acyloxy oder NR³₂ mit R³ gleich Wasserstoff oder Niederalkyl. Alkoxygruppen sind als abhydrolysierbare Gruppen bevorzugt, insbesondere Niederalkoxygruppen wie C₁-C₆-Alkoxy.

Das verfestigbare Organopolysiloxan kann unter Verwendung mindestens eines weiteren Silans der Formel (II)

SiX₄ (II)

erzeugt worden sein, worin X gleich oder verschieden ist und die gleiche Bedeutung wie in Formel (I) besitzt. Eine hierfür gut einsetzbare Verbindung ist Tetraethoxysilan. Durch Zugabe solcher Silane zu der zu hydrolysierenden und kondensierenden Mischung, aus der schließlich das polymerisierbare Badmaterial entsteht, wird der SiO-Anteil des Harzes, also der anorganische Anteil, erhöht. Dadurch lässt sich die Absorption des Harzes in den interessierenden Wellenlängen senken.

Umgekehrt kann das erfindungsgemäß organisch zu polymerisierende Silanpolykondensat unter Verwendung mindestens eines Silans mit der Formel (IV)

R¹ₐSiR²₄₋ₐ (IV)

hergestellt worden sein, worin R¹ und R² die oben für Formel (I) angegebene Bedeutung haben. Dadurch wird der Vernetzungsgrad des Polykondensates heruntergesetzt.

Außerdem kann R¹ ein von R¹ der Formel (I) verschiedener organischer, über Zwei- oder Mehrphotonenpolymerisation polymerisierbarer Rest sein.

Die Mischung, aus der das Silankondensat erzeugt wird, kann weiterhin mindestens ein Silanol der Formel (III)

R⁴ₐSi(OH)₄₋ₐ (III)

enthalten, worin R⁴ gleich oder verschieden sein kann und jeweils entweder die Bedeutung von R¹ wie in Formel (I) definiert oder von R² wie in Formel (I) definiert besitzt und worin der Index a 1, 2 oder 3, vorzugsweise 2 bedeutet. Die Hydrolyse kann in Gegenwart dieser Verbindungen daher mit Hilfe von katalytisch wirksamen Mengen von Wasser erfolgen; im Übrigen kann das System wasserfrei bleiben. In einer bevorzugten Ausgestaltung der Erfindung werden Disilanole der Formel (III) im Mischungsverhältnis von 1:1 (Mol/Mol) mit Silanen der Formel (I), die vorzugsweise eine Gruppe R¹ enthalten, als zu hydrolysierendes und kondensierendes Ausgangsmaterial eingesetzt.

Wenn R¹ in Formel (I) eine C=C-Doppelbindung trägt und R² in dieser Formel nicht vorhanden ist oder keine funktionellen Gruppen besitzt, kann in einer spezifischen Ausgestaltung dem zu hydrolysierenden und kondensierenden Material mindestens ein Silan der Formel (V)

R³ₐSiX₄₋ₐ (V)

zugegeben werden, worin R³ eine Gruppe trägt, die radikalisch an eine C=C-Doppelbindung addiert werden kann, insbesondere eine Thiolgruppe. Entsprechende Kondensate sind dann einer Polymerisation durch Additionsreaktionen der Gruppen R³ der Silane der Formel (V) an Doppelbindungen der Reste R¹ der Silane mit der Formel (I) zugänglich.

Die für die Zwecke der vorliegenden Erfindung zu hydrolysierende und kondensierende Mischung kann weitere Substanzen enthalten, z.B. vorzugsweise niedere Alkoxide, insbesondere C₁-C₆-Alkoxide, von Metallen der III. Hauptgruppe, von Germanium und von Metallen der II., III., IV., V., VI., VII. und VIII. Nebengruppe.

Insgesamt sollte das organisch modifizierte Kieselsäurepolykondensat, aus dem sich die erfindungsgemäßen Körper herstellen lassen, vorzugsweise mindestens 0,1 Mol an einer Zwei- oder Mehrphotonenpolymerisation zugänglichen Gruppen (R¹ der Formel (I)) aufweisen, bezogen auf die Molmenge an Siliciumatomen plus ggf., soweit vorhanden, der Metallatome der III. Hauptgruppe, von Germanium und der II., III., IV., V., VI., VII. und VIII. Nebengruppe.

Das Material, das auf dem genannten Substrat bzw. in der genannten Form verfestigt wird, enthält zusätzlich freie organische Monomere: In einer ersten Variante der Erfindung sind diese Monomere derselben zwei- oder Mehr-Photonenpolymerisation zugänglich wie die Reste R¹ an den (vorkondensierten) Silanen der Formel (I). In einer bevorzugten Ausführungsform handelt es sich dabei um dieselben Reste R¹. In einer stärker bevorzugten Ausführungsform sind die organischen Monomere ausgewählt unter Monomeren, mit deren Hilfe die Silane der Formel (I) erzeugt wurden. Besonders günstig sind hier Acryl- und Methacrylverbindungen wie die (Meth)Acrylate.

Als Beispiele seien Trimethylolpropantriacrylat (TMPTA) oder Dipentaerythritpentacrylat genannt, die z.B. wie in DE 4011044 C2 erläutert mit einem Trialkoxysilan oder mit einem Mercaptoalkylalkyldialkoxysilan oder einem Mercaptoalkyltrialkoxysilan zur Reaktion gebracht werden können. Die Verwendung eines molaren Überschusses an (Meth)Acrylatmolekülen, bezogen auf die Hydrido- bzw. Mercaptogruppen des Silans, führt nach hydrolytischer Kondensation des Silans zu einem Polysiloxan enthaltenden Sol bzw. Gel, das freie (Meth)Acrylat-Moleküle enthält.

In einer alternativen Ausführungsform können die monomeren organisch polymerisierbaren Verbindungen jedoch auch andere Verbindungen sein als die für die Herstellung der Silane verwendeten. Dabei können solche Monomere ausgewählt werden, die sich mit Resten R¹ des Siloxans photochemisch copolymerisieren lassen. Diese reagieren unter Bestrahlung teils mit sich selbst, teils mit den organisch polymerisierbaren Gruppen des Polysiloxans. Als Beispiele seien hier genannt:
1,12-Dodecandioldimethacrylat (DDDMA)
Tetramethylenglykoldimethacrylat (TGMDMA)
Triethylenglycoldimethacrylat (TEGDMA)
Ethylmethacrylat (EMA)
Tridecylmethacrylat (C13MA)
Varianten von Polyethylenglycolmethylether-methacrylat (MPEG500MA)
Bisphenol-A-Ethoxydiacrylat (BED)
Polyethylenglycol-Dimethacrylat (PEG400DMA)
Triethylenglykoltriacrylat
Trimethylolpropantriacrylat (TMPTA)

Die Auswahl dieser Monomeren erfolgt unter Berücksichtigung der Tatsache, dass sie in einem Molekül unterschiedliche Polaritäten, eine unterschiedliche Anzahl an polymerisierbaren Gruppen, insbesondere Methacryl- oder Acrylgruppen, und, bei mehr als einer polymerisierbaren Gruppe, unterschiedliche Kettenlängen zwischen zwei polymerisierbaren Gruppen aufweisen. Wenn Monomere mit mehr als einer polymerisierbaren Gruppe gewählt werden, entstehen dichtere organisch verknüpfte Netzwerke. Mit der Kettenlänge lassen sich mechanische Eigenschaften, wie Elastizität oder E-Modul und dergleichen, einstellen.

Stattdessen können aber auch solche Monomere ausgewählt werden, die andere Reaktionen eingehen. Geeignet hierfür sind beispielsweise Monomere, die mit einem Rest R¹ des Silans auf andere Weise reagieren als durch eine Polymerisationsreaktion. Ein Beispiel ist die Reaktion eines Monomeren, das eine (oder mehrere) Thiolgruppen aufweist, z.B. mit einer (Meth)Acrylguppe des Polysiloxans.

Als Beispiele für geeignete Thiol-Verbindungen seien genannt:
Trimethylolpropantri(3-mercaptopropionat) (TMPMP)
Trimethylolpropantrimercaptoacetat (TMPMA)
Pentaerylthritoltetra(3-mercaptopropionat) (PETMA)
Pentaerythritoltetramercaptoacetat (PETMA)
Glykoldimercaptoacetat
Glykoldi(3-mercaptopropionat)
Ethoxyliertes Trimethylolpropantri(3-mercaptopropionat)
4,4'-Thiobisbenzenthiol
4,4'-Dimercaptostilben.

Wenn Thiol-Verbindungen als Monomere eingesetzt werden, ist es möglich, aber nicht erforderlich, dass das Polysiloxan C=C-Doppelbindungen enthaltende Reste aufweist, die einer Polymerisationsreaktion ("chain growth polymerization, addition polymerization) unterzogen werden können. Es kann jedoch ausreichend sein, dass das Polysiloxan C=C-Doppelbindungen enthält, die aufgrund sterischer oder anderer Umstände dieser Polymerisationsreaktion nicht zugänglich sind, sofern sie mit der Thiol-Verbindung eine Thiol-En-Reaktion eingehen. Das Polysiloxan kann aber auch beispielsweise selbst Thiolgruppen enthalten, beispielsweise durch den Einbau von Mercaptosilanen in das Polysiloxan-Netzwerk, und in diesen Fällen kann ein Monomer gewählt werden, das C=C-Doppelbindungen aufweist, die einer Thiol-En-Reaktion unterworfen werden können. In bevorzugten Fällen besitzt dieses Monomer (Meth)Acrylgruppen, stärker bevorzugt Methacrylgruppen, insbesondere Methacrylatgruppen, wobei die Methacrylatgruppen dann teilweise photoinitiatorinduziert mit am Polysiloxan vorhandenen, organisch polymerisierbaren C=C-Doppelbindungen, teilweise unabhängig vom Vorhandensein eines Photoinitiators mit den Thiolgruppen des Siloxans reagieren können. Solche Silane müssen aber nicht notwendigerweise vor der hydrolytischen Kondensation zugesetzt werden, sondern können auch anschließend als monomere Silane zugegeben werden. Beispiele für geeignete Thiosilane sind:
3-Mercaptopropyl-trimethoxysilan
3-Mercaptopropyl-triethoxysilan
3-Mercaptopropyl-methyldimethoxysilan.

In dieser Ausführungsform ist es auch möglich, dass das Polysiloxan gar keine einer organischen Polymerisation ("chain reaction polymerization") zugängliche C=C-Doppelbindungen aufweist.

Die Menge an monomeren organisch polymerisierbaren Verbindungen ist nicht kritisch, in bevorzugter Weise liegt sie im Bereich von bis zu 0,5 Mol, stärker bevorzugt im Bereich von 0,1 bis 0,3 Mol pro für das Siloxan eingesetztem Mol Silan der Formel (I).

Das organisch modifizierte, polysiloxanhaltige Material enthält weiterhin zumindest dann, wenn die Polymerisation nicht ausschließlich über eine Thiol-En-Addition erfolgt, einen Photoinitiator. Das kann beispielsweise ein Initiator aus der Irgacure^{®}-Familie sein, wie Irgacure^{®} 369, Oxe01 oder Oxe02, oder ein anderer Initiator, wie Lucirin^{®} TPO und -TPO-L. Insbesondere ist auch auf die speziell für die Zwei- und Mehrphotonenpolymerisation entwickelten Initiatoren zu verweisen, die durch Wasserstoffabstraktion wirken, z.B. Irgacure^{®} 369, DPD oder N-DPD (1,5-Diphenyl-penta-1,4-diyn-3-on bzw. das ortho-Dimethylaminoderivat davon), siehe z.B. R. Liska et al. in Applied Surface Science 254, 836-840 (2007) und B. Seidl et al. in Macromol. Chem. Phys. 208, 44-54 (2007). Auch kationische Initiatoren können eingesetzt werden, wenn das polysiloxanhaltige Material beispielsweise Epoxidgruppen enthält. Wenn das Polysiloxan unterschiedliche Reste R¹ aufweist, beispielsweise Methacrylatgruppen und Epoxygruppen, sind auch Mischungen radikalisch wirkender Initiatoren mit kationisch wirkenden Initiatoren möglich. Damit lässt sich eine noch genauere Steuerung der Polymerisation bewirken.

Der Photoinitiator wird vorzugsweise zugegeben, nachdem die anorganische Vernetzung des Materials durch hydrolytische Kondensation des oder der eingesetzten Silane bereits stattgefunden hat. Hierfür wird er eingewogen und unter Rühren in Gelblicht (Reinraumbedingungen, Gelblichtlabor) in die Materialformulierung eingebracht. Danach ist das Material einsatzbereit, kann aber auch noch, falls gewünscht, filtriert werden.

Die Menge an zuzusetzendem Photoinitiator ist nicht kritisch, sie kann z.B. in einem Bereich zwischen 0,1 und 5 Gew.-% liegen. Günstig sind häufig 2 Gew.-%. Wenn das System nichtaktivierbare Doppelbindungen aufweist, beispielsweise in Form von Norbornenylgruppen, kann die Menge an Initiator jedoch deutlich niedriger gewählt werden. Gegebenenfalls kann der Photoinitator sogar weggelassen werden, nämlich dann, wenn ausschließlich Thiol-En-Verknüpfungen gebildet werden sollen, z.B. bei Umsetzung eines norbornenhaltigen Polysiloxans mit einem monomeren Thiol.

Um die Funktionalität des dreidimensionalen Formkörpers mit Bereichen unterschiedlicher Vernetzungsstruktur herzustellen, muss das Material belichtet werden. Hierfür wird dieses auf ein Substrat auf- oder in eine Form eingebracht, wobei es in der Form ein Bad bilden kann. Dies kann durch beliebige, im Stand der Technik bekannte Verfahren erfolgen, beispielsweise Aufschleudern, Rakeln, Dispensieren, Drucken, Tauchen oder Sprühen eines flüssigen oder pastösen Materials, aber auch durch Auflegen und ggf. Befestigen eines bereits verfestigten Materials auf bzw. am Substrat oder in die bzw. in der Form, wobei alle gängigen Substrat- und Form-Materialien verwendet werden können, wie Glas, Silicium, Metalle, und die Schichtdicke völlig variabel, beispielsweise zwischen 100 nm und mehreren mm, gewählt werden kann. Das Substrat kann planar sein, statt dessen aber auch eine unebene Form besitzen; es lassen sich Formkörper beliebiger, auch größerer Abmessung, insbesondere einer relativ großen Höhe fertigen, z.B. im Bereich von 1-10 mm.

Danach wird der Formkörper durch ein Verfahren hergestellt, das mindestens zwei Schritte umfasst. In einem davon wird das flüssige bzw. pastöse oder auch feste Material mit Hilfe eines Lasers, vorzugsweise eines Ultrakurzpulslasers, selektiv an den im Voraus berechneten, gewünschten Stellen verfestigt, an denen die Strukturänderung im fertigen Produkt gewünscht ist, z.B. an denjenigen Orten, die im fertigen Produkt einen höheren Brechungsindex aufweisen sollen. Hierfür wird ein Laserstrahl auf jedes zu verfestigende Volumenelement gerichtet. Geeignet ist hierfür insbesondere eine Bestrahlung mit Femtosekunden-Laserpulsen. Als Strahlquelle können grundsätzlich Festkörperlaser, Dioden-gepumpte Festkörperlaser, Halbleiterlaser, Faserlaser, etc. beliebiger Wellenlänge verwendet werden. Mit besonderem Vorteil wird in einer Ausführungsform der Erfindung ein Ytterbium-Lasersystem verwendet. Dessen Wellenlänge befindet sich bei Frequenzverdopplung im Bereich von grünem Licht. Vorteil von Ytterbium Lasern gegenüber Ti-Saphir-Lasersystemen, die eine Wellenlänge von ca. 800nm besitzen (wobei jedoch auch die zweite Harmonische bei 400 nm genutzt werden kann), ist die Wellenlänge von 1030 nm. Diese liegt bei Frequenzverdoppelung im grünen Bereich bei 515 nm, was zu einer verbesserten Auflösung führen kann. Außerdem können die zu strukturierenden Materialien effizienter bearbeitet werden als mit Lasern in Wellenlängenbereichen von ca. 800 nm. Das Prozessfenster ist hinsichtlich Materialformulierungen deutlich größer. Der Vorteil von Ytterbium-Lasersystemen liegt darin, dass man diese Laser mit Dioden pumpen kann und keinen zusätzlichen Pumplaser und diverse andere Instrumente notwendig sind. Der Vorteil von Ytterbium-Lasern gegenüber Nd:YAG-Lasern sind relativ kurze Pulse. Auch andere Kurzpulslaser können im erfindungsgemäßen Verfahren eingesetzt werden, insbesondere Faserlaser. Bei Verwendung größerer Wellenlängen kann die Polymerisation auch durch eine n-Photonenabsorption initialisiert werden, wobei n größer 2 gilt. Die Schwellen-Fluenz, bei welcher der Polymerisationsprozess startet, kann durch die Wahl geeigneter Komponenten, wie z.B. CoInitiatoren und/oder Aminkomponenten, mit einem erhöhten Mehrphotonen-Absorptionsquerschnitt im Harz gesenkt werden. Dadurch wird das Prozessfenster, in dem die Polymerisation stattfindet, das Material jedoch noch nicht zerstört wird, vergrößert. Selbstverständlich muss das auszuhärtende Material transparent für die verwendete Laserwellenlänge sein.

Die Form und Gestalt des selektiven Bereichs kann frei gewählt werden. In manchen Fällen ist es günstig, einen Basispunkt am Substrat bzw. an der Form zu wählen, von dem ausgehend sich die sich verfestigende Struktur erstreckt. Dies ist jedoch keine notwendige Maßnahme, vielmehr kann die Struktur frei in das Material geschrieben werden, und zwar überraschenderweise auch dann, wenn dieses zuvor auf welche Weise auch immer in einen bereits festen Zustand überführt wurde. Es können beispielsweise Strukturen erzeugt werden, die sich als Wellenleiter eignen.

In einem vorangehenden oder, bevorzugt, nachfolgenden Schritt wird das gesamte auf dem Substrat bzw. in der Form befindliche Material verfestigt. Dies kann entweder durch Bestrahlung oder durch Erwärmen erfolgen. Wird in diesem Schritt eine Bestrahlung verwendet, erfolgt sie vorzugsweise mit UV-Licht, z.B. im Bereich zwischen 200 und 500 nm, ganz besonders bevorzugt bei etwa 365 nm (sogenannte I Linie), also mit einer in etwa doppelten Energie der einfallenden Photonen, verglichen mit der Belichtung während der Zwei-Photonen-Polymerisation. Eine thermische Verfestigung erfolgt vorzugsweise bei Temperaturen im Bereich zwischen 80 und 170°C, wobei der Zeitraum vom Fachmann je nach Größe der Form in geeigneter Weise gewählt werden, kann und z.B. einige Sekunden bis zu mehreren Stunden beträgt. In einer speziellen Ausführungsform können die beiden Maßnahmen kombiniert werden, wobei der Bestrahlung mit UV-Licht die thermische Nachhärtung folgt. Diese Vor- oder Nachbehandlung dient der vollständigen Aushärtung, so dass sichergestellt ist, dass das entstandene Produkt auch über große Zeitspannen hinweg hinsichtlich der optischen und mechanischen Eigenschaften stabil bleibt. Die Brechzahl-Differenz Δn wird hierbei zwar wiederum kleiner, überraschenderweise bleibt sie aber in ausreichendem Maße bestehen und wird nicht aufgehoben, obwohl man aufgrund der Sättigungskurven der TPA-Reaktion davon ausgehen muss, dass in beiden Bereichen alle organisch polymerisierbaren Gruppen, soweit nicht sterisch daran gehindert, vollständig umgesetzt sein sollten.

In allen vorgenannten Ausführungsformen ist es dabei möglich, dass dem Schritt des selektiven Verfestigens ein Vorvernetzungs-Schritt vorangeht. Dies hat den Vorteil, dass das selektive Belichten zur Erzeugung der Bereiche mit z.B. höherem Brechungsindex zu möglicherweise genaueren Strukturen führt, da Diffusionsprozesse und Bewegungsprozesse im Material abgeschwächt oder verhindert sind, die beispielsweise durch den punktuellen Energieeintrag und/oder, falls die Probe bewegt wird und nicht nur der Laser, die Bewegung der Probe während des Belichtungsvorgangs verursacht werden. Völlig überraschend konnten die Erfinder feststellen, dass eine solche Vorhärtung die nachfolgende selektive Erzeugung der gewünschten Strukturen nicht behindert oder verschlechtert. Dabei ist es bevorzugt, die Vorvernetzung auf photochemischem Wege durch Bestrahlung zu bewirken. Die Bestrahlung kann bei denselben Wellenlängen erfolgen wie vorstehend beschrieben; die Dauer liegt bei unter einer Sekunde bis zu ca. 60 Minuten, wobei insbesondere eine Dauer von 1 bis 360 s, hier wiederum insbesondere 5 bis 60 s, günstig ist. Dass dieser Schritt die nachfolgende selektive Vernetzung von mit 2-Photonen-Polymerisation behandelten Bereichen nicht negativ beeinflusst, ist völlig überraschend, wenn man bedenkt, dass die Materialien bereits nach 1 bis 30 s vollständig (d.h. bis zur "Sättigung") vernetzt sind, wie Erfinder seit Jahren aus ihren spektroskopischen Untersuchungen wissen.

Konkret lassen sich mit den vorgenannten Maßnahmen insbesondere fünf definierte Verfahren beschreiben, wie folgt:
Ganz allgemein gilt: Wenn das eingesetzte Ausgangsmaterial flüssig oder pastös ist, wird es auf ein Substrat auf- oder in eine Form oder ein Bad eingebracht. In alternativen Ausführungsformen ist das Ausgangsmaterial bereits fest (manche Polysiloxane, z.B. Styrylgruppen enthaltende, sind nach der vollständigen hydrolytischen Kondensation bereits fest oder halbfest). Im ersteren Falle kann das Auf- oder Einbringen durch beliebige, im Stand der Technik bekannte Verfahren erfolgen, beispielsweise Aufschleudern, Rakeln, Dispensen, Drucken, Tauchen oder Sprühen eines flüssigen oder pastösen Materials, aber auch durch Auflegen und ggf. Befestigen eines bereits verfestigten Materials auf bzw. am Substrat oder in die bzw. in der Form, wobei alle gängigen Substrat- und Form-Materialien verwendet werden können, wie Glas, Silicium, Metalle, und die Schichtdicke völlig variabel gewählt werden kann, beispielsweise zwischen 100 nm und mehreren mm. Das Substrat kann planar sein, statt dessen aber auch eine unebene Form besitzen; es lassen sich Formkörper beliebiger, auch größerer Abmessung, insbesondere einer relativ großen Höhe fertigen, z.B. im Bereich von 1-10 mm.

### Verfahren 1

Im ersten Schritt wird in dem auf dem Substrat/in der Form befindlichen Material mittels einer geeigneten Optik ein ultrakurz gepulster Laserlicht-Fokus erzeugt. Im Laserfokus wird eine Zwei-Photonen-Polymerisation des dort befindlichen Ausgangsmaterials bewirkt. Der Fokus wird so durch das Material bewegt, dass infolge der Zwei- oder Mehr-Photonen-Polymerisation die gewünschten Volumenelemente darin optisch polymerisiert werden, während das umgebende/angrenzende Badmaterial unverändert bleibt ("Laserschreiben"). Nach Fertigstellen des gewünschten Bereichs mit TPA- oder MPA-Vernetzung wird in einem zweiten Schritt das gesamte Bad mit UV-Licht belichtet, vorzugsweise mit einer Wellenlänge von 200-500 nm und besonders bevorzugt von 365 nm (I-Linie).

### Verfahren 2

Dieses Verfahren umfasst die beiden Schritte des Verfahrens 1. Daran schließt sich ein dritter Schritt an, bei dem das gesamte Badmaterial thermischer Energie ausgesetzt wird, beispielsweise in einem Ofen oder durch das Stellen der badgefüllten Form auf eine heiße Platte. Die Dauer dieser Maßnahme wird je nach Bedarf gewählt, sie liegt bei wenigen (z.B. 5) Minuten bis zu einigen (z.B. 8) Stunden. Das Material kann dabei auf Temperaturen von insbesondere zwischen 80 und 170°C aufgeheizt werden. Höhere Temperaturen sind jedoch nicht auszuschließen.

### Verfahren 3

Das eingesetzte Ausgangsmaterial wird in einem ersten Schritt vollständig mit Licht bestrahlt, vorzugsweise mit UV-Licht einer Wellenlänge von 200-500 nm, ganz besonders bevorzugt von 365 nm (I. Linie). Die Dauer der Bestrahlung ist überraschenderweise nicht kritisch; sie kann z.B. zwischen 1 und 3600 s liegen, d.h. bis über die Sättigung der TPA-Reaktion hinaus. Noch längere Belichtungszeiten sind nicht ausgeschlossen. Der zweite und der dritte Schritt entsprechen dem ersten und dem zweiten Verfahrensschritt des Verfahrens 1.

### Verfahren 4

Der erste Verfahrensschritt entspricht dem ersten Verfahrensschritt des Verfahrens 3. Der zweite und der dritte Schritt entsprechen dem zweiten (2-PP/M-PP) und dem dritten Verfahrensschritt (thermische Nachhärtung) des Verfahrens 2.

### Verfahren 5

Gemäß diesem Verfahren wird in einem ersten Schritt das eingesetzt Ausgangsmaterial vollständig mit Licht bestrahlt, wie für Verfahren 3 beschrieben. Daran schließt sich der Schritt des "Laserschreibens" an, wie für Verfahren 1 beschrieben. Von Verfahren 3 unterscheidet sich Verfahren 5 dadurch, dass auf eine nachträgliche Verfestigung verzichtet wird.

In allen vorgenannten Varianten kann zusätzlich mechanischer Druck aufgebracht werden, der je nach dem Anwendungszweck gewählt wird. Hierfür kann beispielsweise von oben ein planares Substrat auf die Oberfläche der dem Verfahren unterworfenen Schicht bzw. der des Formkörpers aufgebracht und das so erhaltene "Sandwich" in eine Presse gegeben werden.

Organisch durch Zwei- oder Mehr-Photonenpolymerisation (2-PP, M-PP) vernetzte Organopolysiloxane, deren organisch vernetzte Gruppen Bestandteile von über Kohlenstoff an Silicium gebundenen Resten sind, sind bevorzugt duroplastische Materialien, die sich durch eine gute Temperaturbeständigkeit sowie eine hervorragende Temperatur-Formbeständigkeit im Vergleich zu den meisten rein organischen Polymeren auszeichnen.

In einer zweiten Ausführungsvariante gemäß Anspruch 12 wird der (einzige) Schritt bzw. werden alle Schritte des Verfestigens des gesamten Materials weggelassen. Man erhält damit durch das "Laserschreiben" erst einmal eine verfestigte Struktur, deren Außenränder zumindest teilweise vom flüssigen oder pastösen Ausgangsmaterial umgeben sind. Dieses Ausgangsmaterial ist aufgrund der fehlenden Vernetzung in vielen Lösungsmitteln löslich, die der Fachmann kennt, beispielsweise in Alkoholen, wässrigen alkoholischen Lösungen, Ketonen oder Mischungen davon, und lässt sich daher in einfacher Weise wegwaschen. Zurück bleibt ein strukturierter Formkörper oder eine strukturierte Oberfläche. Ein derartiges Verfahren eignet sich insbesondere für die Herstellung von Formkörpern oder Oberflächen mit komplizierter Geometrie, die sich mit Hilfe von formenden Verfahren oder mit Maskenbelichtung nur schwer herstellen lassen. Beispiele für derartige Formkörper sind poröse Formkörper, insbesondere mit Poren im µm- oder nm-Bereich, die ggf. eine nicht geradlinige Geometrie aufweisen können. Solche Formkörper werden beispielsweise als Scaffolds (zum Aufwachsenlassen von lebenden Zellen) benötigt.

Eine Reihe von erfindungsgemäß verwendbaren anorganisch vernetzbaren Organopolysiloxanen (Organokieselsäurepolykondensaten) besitzen eine niedrige Absorption im Bereich der für Daten- und Telekommunikation interessierenden Wellenlängen (810 bis 1550 nm). Solche Polymere erhält man beispielsweise, wenn das Kondensat nur noch unbedeutende Anteile an SiOH-Gruppen aufweist oder fast oder ganz frei davon ist. Eine niedrige Absorption erhält man auch z.B. durch Einsatz von Ausgangsmaterialien, deren kohlenstoffhaltige Gruppen ganz oder teilweise fluoriert sind. Weiterhin ist es für diesen Zweck z.B. günstig, den Anteil an SiO-Gruppen im Harz, also den "anorganischen" Anteil, relativ hoch zu halten. Dies gelingt beispielsweise durch Zusatz von Silanen zu der zu hydrolysierenden Mischung, die keine organischen Gruppen enthalten, sondern an allen vier Resten hydrolysiert werden können, z.B. von Tetraalkoxysilanen, wie Tetraethoxysilan. Die im Bereich von 810 bis 1550 nm in den entsprechenden Frequenzbanden wenig lichtabsorbierenden Materialien erlauben es, mit Hilfe des erfindungsgemäßen Verfahrens passive und aktive optische Elemente kostengünstig zu fertigen, deren innere optischen Oberflächen sehr glatt bzw. fein und genau strukturiert sind, wie z.B. Wellenleiter, Prismen, Mikrolinsen oder auch Gitter.

Wie erwähnt, sind Harze auf Organopolysiloxanbasis Materialien, die in einer großen Vielzahl und Vielfalt in Hinblick auf verschiedene physikalische, chemische und biologische Eigenschaften ausgewählt werden können, da sie eine Vielzahl verschiedener funktioneller Gruppen tragen können, welche die physikalischen und chemischen Eigenschaften des Harzes beeinflussen (z.B. Netzwerkbildner, Netzwerkwandler). Daher sind diese Harze für eine Anwendung in den bezeichneten Gebieten von besonderem Vorteil. Dies gilt vor allem für die erfindungsgemäß bevorzugte Nutzung von Femtosekundenlaser-Bestrahlung von Silanharzen.

Die Flexibilität des Verfahrens und der dafür eingesetzten Organopolysiloxane einerseits und ihre Nicht-Toxizität andererseits gestattet ebenfalls eine Anwendung im Bereich der Herstellung beliebig komplizierter, dreidimensionaler Strukturen aus einem virtuellen Modell am Computer.

Nachstehend soll die Erfindung anhand von Ausführungsbeispielen näher erläutert werden. Es wurde bereits deutlich gemacht, dass eine Vielzahl von Polysiloxanen für die Erfindung geeignet ist; da deren Formulierung wiederum aufgrund des Zusatzes einer Vielzahl von Monomeren variiert werden kann, sind die nachfolgenden Beispiele auf ein ausgewähltes Ausgangsmaterial und dessen Abwandlungen beschränkt; dem Fachmann sollte klar sein, dass er statt dessen ein beliebiges der Materialien verwenden kann, deren Herstellung z.B. in den oben angegebenen Druckschriften beschrieben ist, und auch diese in analoger Weise variieren kann.

### 1. Herstellung des Basis-Polysiloxans

Zur Vorlage von 302,3 g (1,02 mol) TMPTA in 1020 ml Essigester und einer ethanolischen KOH-Lösung, die als Katalysator für die Thioladdition dient, werden unter Kühlung 153,3 g (0,85 mol) 3-Mercaptopropylmethyldimethoxysilan zugetropft und bei Raumtemperatur gerührt. Die Vollständigkeit der Umsetzung (Thioladdition) kann mittels Jod-Mercaptan-Test festgestellt werden. Nach Zugabe einer wässrigen HCl zur Hydrolyse wird bei Raumtemperatur gerührt. Der Verlauf der Hydrolyse wird jeweils durch Wassertitration verfolgt. Die Aufarbeitung erfolgt nach 1-tägigem Rühren durch Ausschütteln mit Wasser und Filtration über einen hydrophobierten Filter. Das Lösungsmittel wird abrotiert und anschließend mit Ölpumpenvakuum abgezogen. Es resultiert ein flüssiges Harz mit einer Viskosität von ca. 9 Pas bei 25°C. Der Formulierung werden dann im nächsten Schritt 2 Gew.-% Photoinitiator, bezogen auf die molare Menge an eingesetztem Silan, zugesetzt und unter Rühren im Gelblichtlabor in die Materialformulierung eingerührt. Das entstandene Material wird kann dann filtriert werden und ist sodann einsatzbereit für eines der Verfahren zur Herstellung des erfindungsgemäßen Produkts.

### 2. Zusatz von Monomeren - Allgemeine Vorschrift

Eine Mol-Menge N eines Monomeren, bezogen auf die Mol-Menge M an Silan, die für die Herstellung des Basis-Polysiloxans verwendet wurde, wird unter Rühren (in der Regel bei Umgebungsdruck und -temperatur) dem Polysiloxan zugesetzt und solange gerührt, bis die Komponenten homogen miteinander vermischt sind. Die Molmenge N kann bis zu 0,8 Mol variieren. Anschließend erfolgt die Zugabe des Photoinitiators wie für die Herstellung des Basis-Polysiloxans erläutert.

### 3. Zusatz von Monomeren - konkrete Beispiele

Die unter 2. angegebene allgemeine Vorschrift wurde mit N/M = 0,2 ausgeführt, wobei die folgenden Monomere eingesetzt wurden:
MPEG500MA
DDDMA
TEGDMA
C13MA + BED
EMA BED
C13MA
PEG400MA

### 4. Herstellung des Materials mit strukturell unterschiedlichen Bereichen

Das Material wurde durch Aufschleudern in einer Dicke von 300 bis 500 µm auf ein planares Substrat, z.B. eine Leiterplatte, aufgebracht und anschließend dem obigen "Verfahren 4" unterworfen. Die Belichtungszeit für den ersten Schritt wurde variiert; sie betrug entweder 180 s oder 600 s, was der sechsfachen Dosis der üblicherweise für Ein-Photonen-Prozesse verwendeten Energiedosis entspricht. Dabei wurden Messungen der Brechungsindex-Differenz Δn (der sogenannte Brechungshub) vor und nach dem dritten Schritt, dem thermischen Nachvernetzen, durchgeführt. Die Brechzahlhübe wurden mit dem RNF-Verfahren (Refractive Near-Field) bestimmt; der Fachmann kennt jedoch weitere Methoden zur Bestimmung dieses Parameters. Allgemein kann die Brechzahl von Schichten oder auch Folien z.B. mit einem Prismenkoppler, einem Abbe-Refraktometer oder m-Linien-Spektroskopie bestimmt werden. Der Brechzahlhub des Basis-Polysiloxans wurde mit 0,002 bei 850 nm (ohne thermisches Nachvernetzen) gemessen. Figur 1 gibt die Brechzahlhübe für die Einarbeitung der verschiedenen Monomere wider, wobei TPA für den Schritt der Zwei-Photonen-Polymerisation steht und T für die sich anschließende Temperaturbehandlung; "TPA" allein bedeutet Messung des Brechzahlhubs vor der thermischen Nachvernetzung, "TPA + T" bedeutet Messung nach der thermischen Nachvernetzung. Es lässt sich erkennen, dass die Brechzahlhübe vor der thermischen Nachvernetzung bei einer Belichtungszeit im ersten Schritt von 180 s deutlich höher waren als bei einer Belichtungszeit im ersten Schritt von 600 s. Durch die thermische Nachvernetzung sanken die Werte wieder und wurden außerdem überraschenderweise etwas nivelliert.

## Patentansprüche

1. Schicht oder dreidimensionaler Formkörper aus oder mit einem organisch modifizierten Polysiloxan oder aus einem Derivat davon, dessen Siliciumatome teilweise durch andere Metallatome ersetzt sind, wobei der organische Anteil des Polysiloxans oder Derivats davon ein organisches Netzwerk mit (i) über Kohlenstoff an Silicium und ggf. andere Metallatome gebundenen C=C-Additionspolymeren und/oder Thiol-En-Additionsprodukten, die über eine 2- oder Mehrphotonenpolymerisationsreaktion erhältlich sind, sowie (ii) über C=C-Doppelbindungen copolymerisierten oder durch eine Thiol-En-Addition an Doppelbindungen oder an SH-Gruppen des organischen Restes in das organische Netzwerk eingebundenen organischen Molekülen aufweist, wobei die Schicht oder der Körper zwei Bereiche mit unterschiedlichen Primär- und/oder Sekundärstrukturen aufweist, erhältlich durch das folgende Verfahren:
a) Bereitstellen eines Substrats oder einer Form,
b) Bereitstellen eines Materials, ausgewählt unter organisch modifizierten, polysiloxanhaltigen Materialien, wobei das bereitgestellte Material die folgenden Komponenten aufweist:
(i) mindestens ein organisch modifiziertes Polysiloxan mit Gruppen, die über eine 2- oder Mehrphotonenpolymerisationsreaktion polymerisierbar sind, bei welcher die Bildung entweder von C=C-Additionspolymeren und/oder von Thiol-En-Additionsprodukten möglich ist, wobei mindestens ein Teil dieser Gruppen über ein Kohlenstoffatom an das Polysiloxan angebunden vorliegt, und
(ii) mindestens ein organisches Monomer, das mindestens einen Rest enthält, der sich mit Resten, die derselben 2- oder Mehrphotonenpolymerisation zugänglich sind wie die Gruppen des organisch modifizierten Polysiloxans gemäß (i), photochemisch copolymerisieren oder an diese addieren lässt,
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) thermisches oder photochemisches Behandeln des gesamten auf dem Substrat bzw. in der Form befindlichen Materials, um das gesamte auf dem Substrat oder in der Form befindliche Material zu verfestigen,
mit der Maßgabe, dass die Schritte d) und e) in beliebiger Abfolge durchgeführt werden können.

2. Schicht oder Formkörper nach Anspruch 1, worin das gemäß Stufe (b) bereitgestellte Material ein organisch modifiziertes polysiloxanhaltiges Material umfasst, das durch Hydrolyse und mindestens teilweise Kondensation eines Ausgangsmaterials erhältlich ist, welches mindestens ein Silan der Formel (I)
R¹ₐR²_{b}SiX_{4-a-b} (I)
enthält, worin R¹ gleich oder verschieden ist und einen organischen, über Zwei- oder Mehrphotonenpolymerisation polymerisierbaren Rest darstellt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, enthält oder im Wesentlichen daraus besteht.

3. Schicht oder Formkörper nach Anspruch 2, erhältlich dadurch, dass das Monomer gemäß Schritt (b) (ii) mindestens einen Rest enthält, ausgewählt unter Resten, die über C=C-Doppelbindungen copolymerisierbar oder durch eine Thiol-En-Addition an Doppelbindungen oder an SH-Gruppen des Restes R¹ anbindbar sind, und bevorzugt unter Resten R¹ wie für Formel (I) definiert.

4. Schicht oder Formkörper nach einem der Ansprüche 1 bis 3, worin die Bereiche mit unterschiedlichen Primär- und/oder Sekundärstrukturen unterschiedliche Brechungsindices besitzen und/oder unterschiedliche Vernetzungsstrukturen aufweisen.

5. Schicht oder Formkörper nach einem der voranstehenden Ansprüche, worin das mindestens eine Monomer (ii) ein rein organisches Polymer ist.

6. Verwendung eines Formkörpers nach einem der Ansprüche 1 bis 5 als Wellenleiter.

7. Verfahren zum Herstellen einer dreidimensionalen Schicht oder eines dreidimensionalen Formkörpers, der zwei Bereiche mit unterschiedlichen Primär- und/oder Sekundärstrukturen aufweist, umfassend die Schritte:
a) Bereitstellen eines Substrats oder einer Form,
b) Bereitstellen eines organisch modifizierten, polysiloxanhaltigen Materials, welches die folgenden Komponenten aufweist:
i) mindestens ein organisch modifiziertes Polysiloxan mit Gruppen, die über eine 2- oder Mehrphotonenpolymerisationsreaktion polymerisierbar sind, bei welcher die Bildung entweder von C=C-Additionspolymeren und/oder von Thiol-En-Additionsprodukten möglich ist, wobei mindestens ein Teil dieser Gruppen über ein Kohlenstoffatom an ein Siliciumatom des genannten Polysiloxans angebunden vorliegt, und
(ii) mindestens ein organisches Monomer, das mindestens einen Rest enthält, der sich mit Resten, die derselben 2- oder Mehrphotonenpolymerisation zugänglich sind wie die Gruppen des organisch modifizierten Polysiloxans gemäß (i), photochemisch copolymerisieren lässt,
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) thermisches und/oder photochemisches Behandeln des gesamten auf dem Substrat bzw. in der Form befindlichen Materials, um das gesamte auf dem Substrat oder in der Form befindliche Material zu verfestigen,
mit der Maßgabe, dass die Schritte d) und e) in beliebiger Abfolge durchgeführt werden können.

8. Verfahren nach Anspruch 7, worin die Bereiche mit unterschiedlichen Primär- und/oder Sekundärstrukturen unterschiedliche Brechungsindices besitzen und/oder unterschiedliche Vernetzungsstrukturen aufweisen.

9. Verfahren nach einem der Ansprüche 7 und 8, worin das gemäß Stufe (b) bereitgestellte organisch modifizierte polysiloxanhaltige Material durch Hydrolyse und mindestens teilweise Kondensation eines Ausgangsmaterials erhältlich ist, welches mindestens ein Silan der Formel (I)
R¹ₐR²_{b}SiX_{4-a-b} (I)
enthält, worin R¹ gleich oder verschieden ist und einen organischen, über Zwei- oder Mehrphotonenpolymerisation polymerisierbaren Rest darstellt, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, enthält oder im Wesentlichen daraus besteht.

10. Verfahren nach Anspruch 9, worin das organische Monomer gemäß Schritt (b) (ii) mindestens einen Rest enthält, ausgewählt unter Resten, die über C=C-Doppelbindungen copolymerisierbar oder durch eine Thiol-En-Addition an Doppelbindungen oder an SH-Gruppen des Restes R¹ anbindbar sind, und bevorzugt unter Resten R¹ wie für Formel (I) definiert.

11. Verfahren nach einem der Ansprüche 9 oder 10, **dadurch gekennzeichnet, dass** das Ausgangsmaterial weiterhin mindestens ein weiteres Silan der Formel (II)
SiX₄ (II)
worin X gleich oder verschieden ist und die gleiche Bedeutung wie in Formel (I) besitzt, und/oder
mindestens ein weiteres Silan der Formel (III)
R⁴ₐSi(OH)₄₋ₐ (III)
worin R⁴ gleich oder verschieden sein kann und entweder die Bedeutung von R¹ wie in Formel (I) definiert oder von R² wie in Formel (I) definiert besitzt und worin der Index a 1, 2 oder 3 bedeutet, enthält.

12. Verfahren zum Herstellen einer dreidimensionalen Schicht oder eines dreidimensionalen Formkörpers, das aus einem polysiloxanhaltigen Material besteht,
umfassend die Schritte:
a) Bereitstellen eines Substrats oder einer Form,
b) Bereitstellen eines Materials, welches enthält:
A)
(i) ein Polysiloxan, das durch Hydrolyse und mindestens teilweise Kondensation eines Ausgangsmaterials erhalten wurde, welches mindestens ein Silan der Formel (I)
R¹ₐR²_{b}SiX_{4-a-b} (I)
aufweist, worin R¹ gleich oder verschieden ist und einen organischen, über Kohlenstoff an das Siliciumatom gebundenen und über Zwei- oder Mehrphotonenpolymerisation polymerisierbaren Rest darstellt, der einen oder mehrere nichtaromatische C=C-Doppelbindungen enthält, R² gleich oder verschieden ist und einen organischen, nicht auf diese Art und Weise polymerisierbaren Rest bedeutet, und X ein unter Hydrolysebedingungen vom Silicium abhydrolysierbarer Rest ist, der Index a 1, 2 oder 3 bedeutet, der Index b 0, 1 oder 2 bedeutet und a+b zusammen 1, 2 oder 3 sind, enthält oder im Wesentlichen daraus besteht, oder
(ii) ein Thiolgruppen enthaltendes Polysiloxan,
sowie
B) ein organisches Monomer, das mindestens einen Rest enthält, ausgewählt unter Resten, die durch eine Thiol-En-Addition an Doppelbindungen des Restes R¹ des Polysiloxans (i) oder an die Thiolgruppen des Polysiloxans (ii) in ein organisches Netzwerk einbindbar sind.
c) Auf- oder Anbringen des bereitgestellten Materials auf oder an dem Substrat bzw. Einbringen desselben in die Form,
d) selektives Belichten eines ausgewählten Bereichs von auf dem Substrat bzw. in der Form befindlichem Material mit Hilfe von Zwei- oder Mehr-Photonen-Polymerisation,
e) Trennen des Formkörpers von nicht-belichtetem Material durch Waschen des Körpers in einem Lösungsmittel, in welchem sich das gemäß Schritt (b) bereitgestellte Material löst.

13. Verfahren nach Anspruch 12, **dadurch gekennzeichnet, dass** das Polysiloxan unter Verwendung mindestens eines weiteren Silans der Formel (II)
SiX₄ (II)
worin X gleich oder verschieden ist und die gleiche Bedeutung wie in Formel (I) besitzt, und/oder mindestens eines weiteren Silans der Formel (III)
R⁴ₐSi(OH)₄₋ₐ (III)
worin R⁴ gleich oder verschieden sein kann und entweder die Bedeutung von R¹ wie in Formel (I) definiert oder von R² wie in Formel (I) definiert besitzt und worin der Index a 1, 2 oder 3 bedeutet, erhalten wurde.

14. Verfahren nach einem der Ansprüche 12 und 13 zur Erzeugung eines porösen Formkörpers, insbesondere eines Formkörpers mit Poren im µm- oder nm-Bereich und/oder eines als Scaffold geeigneten Formkörpers.

## Claims

1. A layer or three-dimensional shaped body made of or with an organically modified polysiloxane or of a derivative thereof, the silicon atoms of which are partially replaced by other metal atoms, wherein the organic portion of the polysiloxane or derivative thereof has an organic network with (i) C=C addition polymers and/or thiol-ene addition products obtainable by 2- or multi-photon polymerization and bonded via carbon to silicon and optionally to other metal atoms, and (ii) organic molecules which are copolymerised via C=C double bonds or are bound into the organic network by a thiol-ene addition to double bonds or to SH groups of the organic radical, wherein the layer or body has two regions with different primary and/or secondary structures, obtainable by the following process:
a) providing a substrate or mould,
b) providing a material selected from organically modified polysiloxane-containing materials, wherein the provided material comprises the following components:
(i) at least one organically modified polysiloxane having groups polymerisable via a 2- or multi-photon polymerisation reaction, in which the formation of either C=C addition polymers and/or thiol-ene addition products is possible, wherein at least part of said groups is attached to the polysiloxane via a carbon atom, and
(ii) at least one organic monomer containing at least one radical which can be photochemically copolymerised with or added to radicals which are accessible to the same 2- or multi-photon polymerisation as the groups of the organically modified polysiloxane according to (i),
(c) attaching or placing the provided material to or on the substrate or placing it in the mould,
(d) selectively exposing a selected area of material on the substrate or in the mould using 2- or mulit-photon polymerisation,
(e) thermal or photochemical treatment of all the material on the substrate or in the mould to solidify all the material on the substrate or in the mould,
with the proviso that steps d) and e) may be carried out in any sequence.

2. The layer or shaped body according to claim 1, wherein the material provided according to step (b) comprises or consists essentially of an organically modified polysiloxane-containing material obtainable by hydrolysis and at least partial condensation of a starting material comprising at least one silane of formula (I)
R¹ₐR²_{b}SiX_{4-a-b} (I)
wherein R¹ is the same or different and is an organic radical polymerisable via 2- or multi-photon polymerisation, R² is the same or different and is an organic radical not polymerisable in this manner, and X is a radical which can be hydrolysed off silicon under hydrolysis conditions, the subscript a is 1, 2 or 3, the subscript b is 0, 1 or 2 and a+b is 1, 2 or 3.

3. The layer or shaped body according to claim 2, obtainable in that the monomer according to step (b) (ii) contains at least one radical selected from radicals which can be copolymerised via C=C double bonds or can be attached to double bonds or to SH groups of the radical R¹ by a thiol-ene addition, and preferably from radicals R¹ as defined for formula (I).

4. The layer or shaped body according to any one of claims 1 to 3, wherein the regions with different primary and/or secondary structures have different refractive indices and/or have different crosslinking structures.

5. The layer or shaped body according to any one of the preceding claims, wherein the at least one monomer (ii) is a purely organic polymer.

6. The use of a shaped body according to any one of claims 1 to 5 as a waveguide.

7. A method of producing a three-dimensional layer or a three-dimensional shaped body having two regions with different primary and/or secondary structures, comprising the steps:
a) providing a substrate or mould,
b) providing a material selected from organically modified polysiloxane-containing materials, wherein the provided material comprises the following components:
(i) at least one organically modified polysiloxane having groups polymerisable via a 2- or multi-photon polymerisation reaction, in which the formation of either C=C addition polymers and/or thiol-ene addition products is possible, wherein at least part of said groups is attached to the polysiloxane via a carbon atom, and
(ii) at least one organic monomer containing at least one radical which can be photochemically copolymerised with or added to radicals which are accessible to the same 2- or multi-photon polymerisation as the groups of the organically modified polysiloxane according to (i),
(c) attaching or placing the provided material to or on the substrate or placing it in the mould,
(d) selectively exposing a selected area of material on the substrate or in the mould using 2- or mulit-photon polymerisation,
(e) thermal or photochemical treatment of all the material on the substrate or in the mould to solidify all the material on the substrate or in the mould,
with the proviso that steps d) and e) may be carried out in any sequence.

8. The method according to claim 7, wherein the regions with different primary and/or secondary structures have different refractive indices and/or have different cross-linking structures.

9. The method according to any one of claims 7 and 8, wherein the organically modified polysiloxane-containing material provided according to step (b) is obtainable by hydrolysis and at least partial condensation of a starting material comprising or consisting essentially of at least one silane of formula (I)
R¹ₐR²_{b}SiX_{4-a-b} (I)
wherein R¹ is the same or different and is an organic radical polymerisable via 2- or multi-photon polymerisation, R² is the same or different and is an organic radical not polymerisable in this way, and X is a radical which can be hydrolysed off the silicon under hydrolysis conditions, the subscript a is 1, 2 or 3, the subscript b is 0, 1 or 2 and a+b is 1, 2 or 3.

10. The method according to claim 9, wherein the organic monomer according to step (b) (ii) contains at least one radical selected from radicals copolymerisable via C=C double bonds or bondable by a thiol-ene addition to double bonds or to SH groups of the radical R¹, and preferably from radicals R¹ as defined for formula (I).

11. The method according to any one of claims 9 or 10, **characterized in that** the starting material further comprises at least one further silane of formula (II)
SiX₄ (II)
in which X is identical or different and has the same meaning as in formula (I), and/or at least one further silane of the formula (III)
R⁴ₐSi(OH)₄₋ₐ (III)
wherein R⁴ may be the same or different and has either the meaning of R¹ as defined in formula (I) or of R² as defined in formula (I) and wherein the subscript a is 1, 2 or 3.

12. A method of manufacturing a three-dimensional layer or a three-dimensional shaped body consisting of a polysiloxane-containing material, comprising the steps:
a) providing a substrate or mould,
b) providing a material which contains:
A)
(i) a polysiloxane obtained by hydrolysis and at least partial condensation of a starting material comprising or consisting essentially of at least one silane of formula (I)
R¹ₐR²_{b}SiX_{4-a-b} (I)
in which R¹ is identical or different and is an organic radical which is bonded to the silicon atom via carbon, can be polymerised via 2- or multi-photon polymerisation and contains one or more non-aromatic C=C double bonds, R² is identical or different and is an organic radical, radical which cannot be polymerised in this way, and X is a radical which can be hydrolysed from silicon under hydrolysis conditions, the subscript a is 1, 2 or 3, the subscript b is 0, 1 or 2 and a+b together are 1, 2 or 3, or
(ii) a polysiloxane containing thiol groups, and
B) an organic monomer containing at least one radical selected from radicals which can be incorporated into an organic network by thiol-ene addition to double bonds of the radical R¹ of the polysiloxane (i) or to the thiol groups of the polysiloxane (ii).
(c) attaching or placing the provided material to or on the substrate or placing it in the mould,
d) selectively exposing a selected area of material on the substrate or in the mould using 2- or multi-photon polymerisation,
e) separating the shaped body from unexposed material by washing the body in a solvent in which the material provided according to step (b) dissolves.

13. The method according to claim 12, **characterized in that** the polysiloxane is prepared using at least one further silane of the formula (II)
SiX₄ (II)
in which X is identical or different and has the same meaning as in formula (I), and/or at least one further silane of the formula (III)
R⁴ₐSi(OH)₄₋ₐ (III)
wherein R⁴ may be the same or different and has either the meaning of R¹ as defined in formula (I) or of R² as defined in formula (I) and wherein the subscript a is 1, 2 or 3.

14. The method according to any one of claims 12 and 13 for producing a porous shaped body, in particular a shaped body with pores in the µm or nm range and/or a shaped body suitable as a scaffold.

## Revendications

1. Couche ou corps moulé tridimensionnel comportant ou constitué(e) d'un polysiloxane organiquement modifié ou d'un dérivé de ce dernier, dont les atomes de silicium sont partiellement remplacés par d'autres atomes métalliques, dans lequel/laquelle la fraction organique du polysiloxane ou de son dérivé présente un réseau organique comportant (i) des polymères d'addition C=C et/ou produits d'addition thiol-ène liés par l'intermédiaire du carbone au silicium et le cas échéant d'autres atomes métalliques, qui peuvent être obtenus au moyen d'une réaction de polymérisation à au moins deux photons, et (ii) des molécules organiques copolymérisées par l'intermédiaire de liaisons doubles C=C ou incorporées dans le réseau organique par l'intermédiaire d'une addition thiol-ène sur des liaisons doubles ou sur des groupes SH du reste organique, dans lequel/laquelle la couche ou le corps présente deux zones de structures primaires et/ou secondaires différentes et peut être obtenu(e) par le procédé suivant :
a) préparation d'un substrat ou d'un moule,
b) préparation d'un matériau sélectionné parmi des matériaux contenant un polysiloxane, organiquement modifiés, le matériau préparé présentant les composants suivants :
(i) au moins un polysiloxane organiquement modifié comportant des groupes qui peuvent être polymérisés au moyen d'une réaction de polymérisation à au moins deux photons permettant la formation soit de polymères d'addition C=C et/ou de produits d'addition thiol-ène, au moins une partie de ces groupes étant liée au polysiloxane par l'intermédiaire d'un atome de carbone, et
(ii) au moins un monomère organique contenant au moins un reste qui peut être copolymérisé par voie photochimique avec des restes, qui peuvent subir la même réaction de polymérisation à au moins deux photons que les groupes du polysiloxane organiquement modifié selon (i), ou être ajouté à ceux-ci,
c) application du matériau préparé sur le substrat ou introduction dudit matériau dans le moule,
d) exposition sélective d'une zone sélectionnée du matériau se trouvant sur le substrat ou dans le moule au moyen d'une polymérisation à au moins deux photons,
e) traitement thermique et/ou photochimique de la totalité du matériau se trouvant sur le substrat ou dans le moule, afin de solidifier la totalité du matériau se trouvant sur le substrat ou dans le moule,
à condition que les étapes d) et e) puissent être effectuées dans un ordre quelconque.

2. Couche ou corps moulé selon la revendication 1, où le matériau préparé selon l'étape (b) comprend un matériau contenant un polysiloxane organiquement modifié qui peut être obtenu par hydrolyse et condensation au moins partielle d'une matière première, lequel contient ou est composé sensiblement d'au moins un silane de formule (I)
RⁱₐR²_{b}SiX_{4-a-b} (I)
où R¹ est identique ou différent et représente un reste organique qui peut être polymérisé au moyen d'une polymérisation à au moins deux photons, R² est identique ou différent et signifie un reste organique qui ne peut pas être polymérisé de cette manière et X représente un reste qui peut être séparé du silicium par l'intermédiaire de conditions d'hydrolyse, l'indice a signifie 1, 2 ou 3, l'indice b signifie 0, 1 ou 2 et a+b signifient ensemble 1, 2 ou 3.

3. Couche ou corps moulé selon la revendication 2, qui peut être obtenu(e) de telle sorte que le monomère selon l'étape (b) (ii) contient au moins un reste, sélectionné parmi des restes qui peuvent être copolymérisés par l'intermédiaire de liaisons doubles C=C et peuvent être liés par l'intermédiaire d'une addition thiol-ène sur des liaisons doubles ou à des groupes SH du reste R¹, et de préférence dans des restes R¹ comme défini pour la formule (I).

4. Couche ou corps moulé selon une des revendications 1 à 3, où les zones de structures primaires et/ou secondaires différentes possèdent des indices de réfraction différents et/ou présentent des structures de réticulation différentes.

5. Couche ou corps moulé selon une des revendications précédentes, où l'au moins un monomère (ii) est un polymère organique pur.

6. Utilisation d'un corps moulé selon une des revendications 1 à 5 comme guide d'ondes.

7. Procédé destiné à la fabrication d'une couche tridimensionnelle ou d'un corps moulé tridimensionnel qui présente deux zones de structures primaires et/ou secondaires différentes, comprenant les étapes :
a) préparation d'un substrat ou d'un moule,
b) préparation d'un matériau contenant un polysiloxane organiquement modifié, qui présente les composants suivants :
(i) au moins un polysiloxane organiquement modifié comportant des groupes qui peuvent être polymérisés au moyen d'une réaction de polymérisation à au moins deux photons permettant la formation soit de polymères d'addition C=C et/ou de produits d'addition thiol-ène, au moins une partie de ces groupes étant liée par l'intermédiaire d'un atome de carbone à un atome de silicium dudit polysiloxane, et
(ii) au moins un monomère organique contenant au moins un reste qui peut être copolymérisé par voie photochimique avec des restes qui peuvent subir la même réaction de polymérisation à au moins deux photons que les groupes du polysiloxane organiquement modifié selon (i),
c) application du matériau préparé sur le substrat ou introduction dudit matériau dans le moule,
d) exposition sélective d'une zone sélectionnée du matériau se trouvant sur le substrat ou dans le moule au moyen d'une polymérisation à au moins deux photons,
e) traitement thermique et/ou photochimique de la totalité du matériau se trouvant sur le substrat ou dans le moule afin de solidifier la totalité du matériau se trouvant sur le substrat ou dans le moule,
à condition que les étapes d) et e) puissent être effectuées dans un ordre quelconque.

8. Procédé selon la revendication 7 où les zones de structures primaires et/ou secondaires différentes possèdent des indices de réfraction différents et/ou présentent des structures de réticulation différentes.

9. Procédé selon une des revendications 7 et 8, où le matériau contenant un polysiloxane organiquement modifié préparé selon l'étape (b) peut être obtenu par hydrolyse et condensation au moins partielle d'une matière première, lequel contient ou est composé sensiblement d'au moins un silane de formule (I) :
RⁱₐR²_{b}SiX_{4-a-b} (I)
où R¹ est identique ou différent et représente un reste organique qui peut être polymérisé au moyen d'une polymérisation à au moins deux photons, R² est identique ou différent et signifie un reste organique qui ne peut pas être polymérisé de cette manière et X représente un reste qui peut être séparé du silicium par l'intermédiaire de conditions d'hydrolyse, l'indice a signifie 1, 2 ou 3, l'indice b signifie 0, 1 ou 2 et a+b signifient ensemble 1, 2 ou 3.

10. Procédé selon la revendication 9, où le monomère organique selon l'étape (b) (ii) contient au moins un reste, sélectionné parmi des restes qui peuvent être copolymérisés par l'intermédiaire de liaisons doubles C=C et peuvent être liés par l'intermédiaire d'une addition thiol-ène sur des liaisons doubles ou à des groupes SH du reste R¹, et de préférence dans des restes R¹ comme défini pour la formule (I).

11. Procédé selon une des revendications 9 ou 10, **caractérisé en ce que** la matière première contient en outre au moins un autre silane de formule (II)
SiX₄ (II)
où X est identique ou différent et possède la même signification qu'en formule (I), et/ou contient au moins un autre silane de formule (III)
R⁴ₐSi(OH)₄₋ₐ (III)
où R⁴ peut être identique ou différent et possède soit la signification de R¹ comme défini en formule (I) soit de R² comme défini en formule (I) et où l'indice a signifie 1, 2 ou 3.

12. Procédé destiné à la fabrication d'une couche tridimensionnelle ou d'un corps moulé tridimensionnel qui est composé d'un matériau contenant un polysiloxane, comprenant les étapes :
a) préparation d'un substrat ou d'un moule,
b) préparation d'un matériau qui contient :
A)
(i) un polysiloxane qui a été obtenu par hydrolyse et condensation au moins partielle d'une matière première, lequel contient ou est composé sensiblement d'au moins un silane de formule (I)
RⁱₐR²_{b}SiX_{4-a-b} (I)
où R¹ est identique ou différent et représente un reste lié à l'atome de silicium par l'intermédiaire du carbone et qui peut être polymérisé au moyen d'une polymérisation à au moins deux photons, qui contient une ou plusieurs liaisons doubles C=C non aromatiques, R² est identique ou différent et signifie un reste organique qui ne peut pas être polymérisé de cette manière et X représente un reste qui peut être séparé du silicium par l'intermédiaire de conditions d'hydrolyse, l'indice a signifie 1, 2 ou 3, l'indice b signifie 0, 1 ou 2 et a+b signifient ensemble 1, 2 ou 3,
ou
(ii) un polysiloxane contenant des groupes thiol,
et
B) un monomère organique qui contient au moins un reste sélectionné parmi des restes qui peuvent être liés par l'intermédiaire d'une addition thiol-ène sur des liaisons doubles du reste R¹ du polysiloxane (i) ou aux groupes thiol du polysiloxane (ii) dans un réseau organique ;
c) application du matériau préparé sur le substrat ou introduction dudit matériau dans le moule,
d) exposition sélective d'une zone sélectionnée du matériau se trouvant sur le substrat ou dans le moule au moyen d'une polymérisation à au moins deux photons,
e) séparation du corps moulé de matériau non exposé par lavage du corps dans un solvant dans lequel le matériau préparé selon l'étape (b) se dissout.

13. Procédé selon la revendication 12, **caractérisé en ce que** le polysiloxane a été obtenu en utilisant au moins un autre silane de formule (II)
SiX₄ (II)
où X est identique ou différent et possède la même signification qu'en formule (I), et/ou au moins un autre silane de formule (III)
R⁴ₐSi(OH)₄₋ₐ (III)
où R⁴ peut être identique ou différent et possède soit la signification de R¹ comme défini en formule (I) ou de R² comme défini en formule (I) et où l'indice a signifie 1, 2 ou 3.

14. Procédé selon une des revendications 12 et 13 pour la production d'un corps moulé poreux, en particulier d'un corps moulé avec des pores compris dans la plage µm ou nm et/ou d'un corps moulé approprié sous forme de matrice.
